# EUROPEAN PATENT APPLICATION

(11) **EP 1 962 567 A2**
(43) Date of publication of application: **27.08.2008**
(21) Application number: 08250012.5
(22) Date of filing: 03.01.2008
(51) Int. Cl.: H05K 1/11, H05K 3/30

(54) **Press-fit pin and board structure**

(30) Priority: 26.02.2007 JP 2007045850
(71) Applicant: Hitachi, Ltd., Chiyoda-ku Tokyo 100-8280 (JP)
(72) Inventor: Sueyoshi, Junya, Chiyoda-ku Tokyo 100-8220 (JP)
(74) Representative: Hodsdon, Stephen James

(57) **Abstract**

Provided is a printed wiring board (2) formed with a through-hole (21) into which a press-fit pin (1) is press-fitted. The printed wiring board includes at least one signal transmission layer, a signal transmission wiring pattern (22a) formed in the signal transmission layer, and an electrode portion of the signal transmission wiring pattern exposed at an inner circumferential surface (21 b) of the through-hole. The electrode portion is not formed covering the entire inner circumferential surface of the through-hole but at a part of the inner circumferential surface of the through-hole.

## Description

This application relates to and claims priority from Japanese Patent Application No. 2007-045850, filed on February 26, 2007, the entire disclosure of which is incorporated herein by reference.
The present invention relates to a junction technique using a press-fit pin, and in particular relates to a structure for a printed wiring board formed with a through-hole for press fitting of a press-fit pin.

A press-fit pin junction technique is a technique in which the press-fit pin, which is an acicular terminal given the property of compressive elasticity, is fitted into a through-hole in a printed wiring board to ensure a frictional force (retaining force), thereby being mechanically and electrically fixed to the printed wiring board. The press-fit pin may be called a compliant pin. A copper-plated electrode portion is formed on an inner circumferential surface of a conventional through-hole. The electrode portion contributes to a retaining force b etween the through-hole and the press-fit pin. A male connector (plug connector) is attached to the press-fit pin fixed to the printed wiring board, and is fitted to a female connector (receptacle connector), thereby establishing lead-free mechanical/electrical connection. With growing awareness of environmental problems, etc., this kind of junction technique using a press-fit pin has been attracting attention as an alternative to soldering techniques using lead.

For example, JP2003-283093 A discloses a technique in which: a printed wiring board layer for high-speed transmission signals and a printed wiring board layer for low-speed transmission signals, which have been separately manufactured, are overlaid via an insulating resin layer; and a press-fit connector pin is press-fitted into communicating holes provided in the respective printed wiring board layers, thereby electrically connecting the printed wiring board layers with the press-fit connector pin and mechanically holding the connection.

Further, JP09-219228 A discloses a technique in which an external conductor fixed to a housing is press-fitted into a through-hole formed in a board to be connected with a ground in the board through press fitting.

Furthermore, JP2005-222821 A discloses a technique in which embossed portions protrude at a crimping portion of a press-fit terminal that electrically comes into contact with a contact portion of a through-hole of a printed wiring board, thereby preventing the press-fit terminal from coming loose.

With the recent developments in hardware technology, the signal transmission rate between electronic components is becoming increasingly high. Therefore, a high-speed serial transmission system has now become mainstream since a conventional parallel transmission system has the problem of a significant impact from "skew" in high rate (high-frequency) bands.

The above-described through-hole, which is provided on the board and into which the press-fit pin of the connector is fitted, has electrostatic capacitance, which causes impedance mismatching, particularly in the high rate bands. This can potentially result in transmission loss due to signal skew. The electrostatic capacitance is determined by the diameter of the through-hole, the dielectric constant of the medium (board material), the number of board layers, and the distance between the board layers.

On the other hand, the demand for downsizing a board has been increasing, and this had led to downsizing the through-holes themselves. Also, the increase in density and number of layers of the board increasingly presents the problem of increased electrostatic capacitance in the through-holes. Accordingly, under a high-speed transmission system, it is important to suppress electrostatic capacitance of the through-holes in the printed wiring board which is downsized and integrated in high density and in high multilayered.

Furthermore, the sufficient contact force between the press-fit pin and the through-hole may not be ensured by merely reducing the area of the electrode portion of the through-hole to suppress the electrostatic capacitance of the through-hole. Therefore, the contact force between the press-fit pin and the through-hole needs to be ensured while the area of the electrode portion of the through-hole is reduced as much as possible.

The present invention has been made in light of the above-stated problems. The invention according to a first aspect relates to a structure of a printed wiring board. Namely, this aspect of the invention provides a board that is formed with a first through-hole, the board being characterized by including: at least one signal transmission layer; a signal transmission wiring pattern formed in the signal transmission layer; and an electrode portion of the signal transmission wiring pattern exposed at the inner circumferential surface of the first through-hole.

Further, the invention according to a second aspect relates to a press-fit pin used for the above-described printed wiring board. Namely, this aspect of the invention provides a press-fit pin that is to be press-fitted into a through-hole formed in a multilayer board, the press-fit pin including: a terminal portion; a press-fit portion that is connected to the terminal portion and has compressive elasticity in a transverse direction; and a tip end portion that is connected to the press-fit portion, the press-fit pin being characterized in that the press-fit portion has a lock portion configured to engage with the inner circumferential surface of the through-hole in a direction of extraction of the press-fit pin.

The electrode is preferably not formed covering the entire inner circumferential surface of the through-hole. Accordingly, even when the through-hole of the printed wiring board is made small, the electrostatic capacitance of the through-hole is suppressed. Therefore, a downsizing of the board can be attained, and also, the increase in the number of wiring layers of the printed wiring board can be flexibly dealt with, allowing a reduction in the cost of the board.

Furthermore, the electrostatic capacitance of the through-holes is suppressed. Thus, signal transmission loss is decreased even in the high rate bands. As a result, the quality of signal waveforms can be maintained.

In addition, with respect to the new problem of the reduced retaining force due to the electrode not covering the entire inner circumferential surface of the through-hole, the sufficient retaining force or locking force can be ensured by providing the lock portion in the press-fit pin. By way of this configuration, the press-fit pin can be prevented from coming loose with certainty.

### Brief Description of the Drawings

Fig. 1 is a partial perspective view showing press-fit pins and a printed wiring board according to an embodiment of the present invention.

Fig. 2 is a partial sectional view illustrating the printed wiring board in which the press-fit pins are press-fitted into through-holes, and to which a connector is attached according to an embodiment of the invention.

Fig. 3 is a diagram illustrating a product example using the printed wiring board configured to include the press-fit pin according to an embodiment of the invention.

Fig. 4 is a diagram illustrating the retaining force of the press-fit pin according to an embodiment of the invention.

Fig. 5 is a graph showing the relationship between the compression displacement amount in a transverse direction and the retaining force of the press-fit pin according to an embodiment of the invention.

Fig. 6 shows a partial side view and a partial frontal view illustrating the press-fit portion of the press-fit pin according to an embodiment of the invention.

Fig. 7 is a diagram illustrating a mounted state of the printed wiring board using the press-fit pins according to an embodiment of the invention.

Fig. 8 is a diagram illustrating the press-fit pin in the through-hole according to an embodiment of the invention.

Figs. 9A and 9B are diagrams illustrating the connection relationship between the press-fit in and a signal transmission wiring pattern in the printed wiring board according to an embodiment of the invention.

Fig. 10 is a diagram of an application example of the press-fit pin and the printed wiring board according to an embodiment of the invention.

Fig. 11 is a diagram of a modified example of the press-fit pin according to an embodiment of the invention.

Fig. 12 is a diagram of a modified example of the printed wiring board according to an embodiment of the invention.

An embodiment of this invention will be described with reference to the attached drawings.

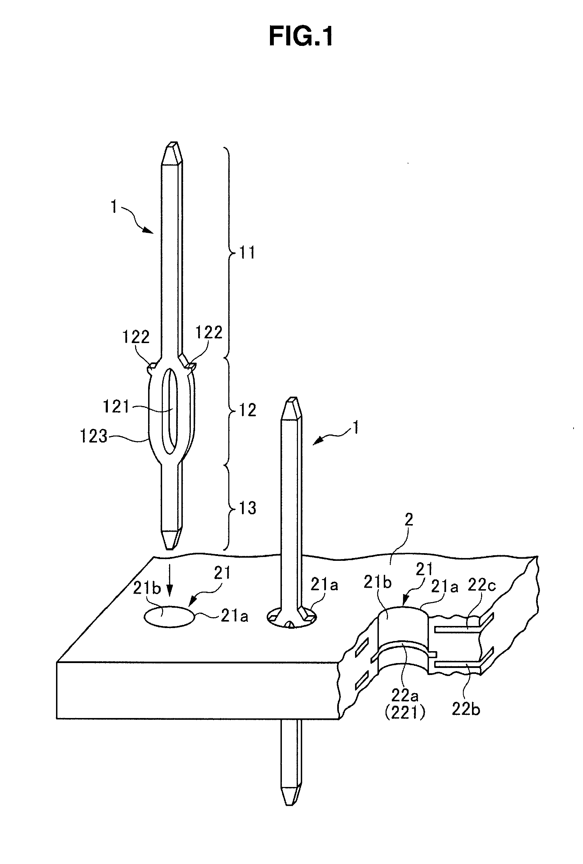

Fig. 1 is a partial perspective view showing press-fit pins 1 and a printed wiring board 2 according to an embodiment of the invention.

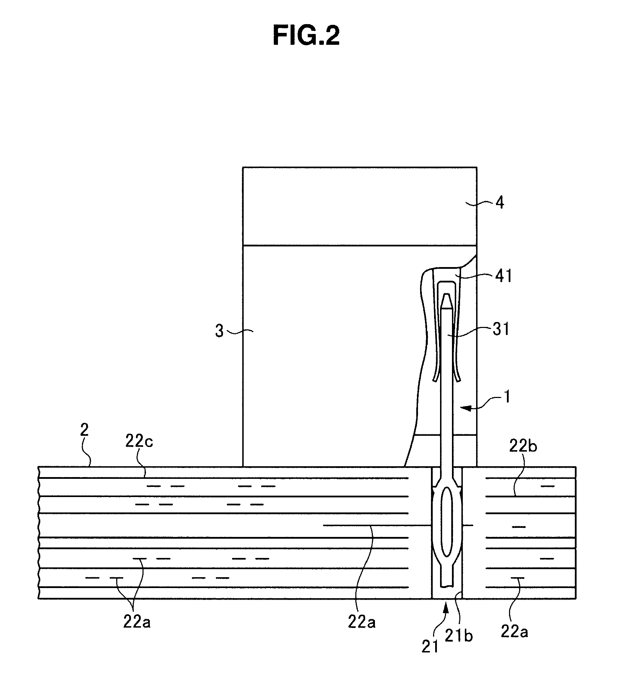

Referring to Fig. 1, press-fit pins 1 are press-fitted into through-holes 21 through opening portions 21a, which are formed in the printed wiring board 2, to be fixed to the printed wiring board 2. Each press-fit pin 1 fixed to the print wiring board 2 mechanically retains a housing of a plug connector 3 to serve as a terminal 31 of the plug connector 3 (see Fig. 2). The plug connector 3 is fitted with another connector (receptacle connector) 4, thereby allowing the terminal 31 and a terminal 41 of the respective connectors to be electrically connected with each other.

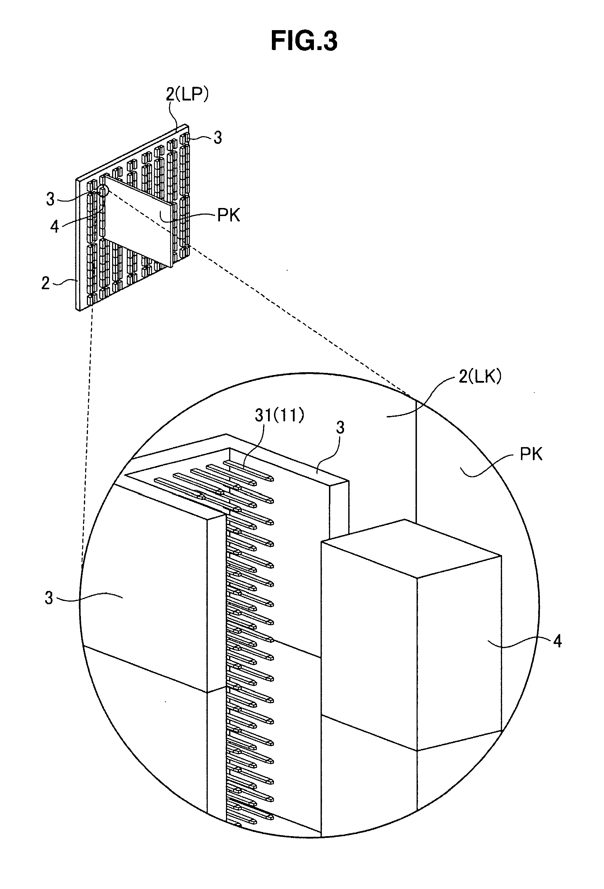

Fig. 3 is a diagram illustrating a product example using the printed wiring board 2 configured to include the press-fit pins 1 according to an embodiment of the invention. The printed wiring board 2 corresponds to a logic platter LP attached in, for instance, a disk array device. The logic platter LP is a board for mounting various kinds of package blades PK such as channel adopter boards and switching boards. In the logic platter LP, multiple plug connectors 3 are arranged, and various electronic components such as LSIs are mounted. Each plug connector 3 on the logic platter LP includes the multiple terminals 31, as shown in the partially enlarged view. The package blade PK is provided with the receptacle connector 4. The receptacle connector 4 is connected to the plug connector 3 of the logic platter LP, so that the package blade PK is mounted on the logic platter LP.

Returning to Fig. 1, the printed wiring board 2 is a multilayer board formed by laminating, for instance, layers of FR-4 board material via a prepreg that functions as an adhesive material. The printed wiring board 2 typically consists of four to ten wiring layers, but there is no limitation on the number of layers. The thickness of each layer constituting the printed wiring board 2 is typically about 0.1 to 0.4 mm, so the thickness of the entire printed wiring board 2 is about 1 to 6 mm. Examples of the wiring layers in the printed wiring board 2 include a power supply layer, a ground layer, and a signal transmission layer, and each layer has a wiring pattern 22 made of a film of metal such as copper. The thickness of the wiring pattern 22 is typically about 35 µm. The signal transmission layer may include a low-speed signal transmission layer and a high-speed signal transmission layer.

The printed wiring board 2 is provided with the through-holes 21. Each through-hole 21 is formed by laminating layers of the FR-4 board material and then perforating the layers at predetermined positions in accordance with a wired pattern profile. Alternatively, each through-hole 21 may be formed by perforating respective layers made of the FR-4 board material and then laminating the layers.

An inner circumferential surface 21 b of the through-hole 21 shown in the figure has not been plated, and thus, a part of the wiring pattern is exposed. More precisely, formed as the through-holes 21 are one having the non-plated inner circumferential surface 21 b and one having the plated inner circumferential surface 21 b. The non-plated through-hole 21 is mainly used for the press-fit pin 1 to be connected to a signal transmission wiring pattern 22a in the signal transmission layer. In other words, in the non-plated through-hole 21, a power supply wiring pattern 22b of the power supply layer and a ground wiring pattern 22c in the ground layer (collectively referred to as "non-signal transmission wiring patterns") are not exposed at the inner circumferential surface 21 b, whereas the signal transmission wiring pattern 22a is exposed as is at the inner circumferential surface 21 b to form an electrode portion 221. This enables electrical connection with the press-fit pin 1.

On the contrary, the plated through-hole 21 is used for the press-fit pin 1 to be connected with the non-signal transmission wiring pattern in each of the power supply layer and the ground layer. Alternatively, the through-hole 21 may be used for connection with an electrode of the circuit component of the LSI or the like mounted on the surface of the printed wiring board 2. In that case, the entire inner circumferential surface 21 b of the plated through-hole 21 serves as the electrode portion 221 in each of the power supply wiring pattern 22b and the ground wiring pattern 22c.

Therefore, the press-fit pin 1 press-fitted into the through-hole 21 is against the inner circumferential surface 21b of the through-hole 21, is mechanically fixed to the printed wiring board 2, and then, is electrically connected with the electrode portion 221 of the inner circumferential surface 21b.

The press-fit pin 1 includes a terminal portion 11, a press-fit portion 12, and a tip end portion 13. The press-fit pin 1 may be provided with a shoulder portion (not shown in the drawing), which extends in a transverse direction, between the terminal portion 11 and the press-fit portion 12. The shoulder portion holds the housing, and is fitted to a recess formed in the housing of the plug connector 3. Alternatively, the shoulder portion may extend beyond the diameter of the through-hole 21, thereby preventing over insertion of the press-fit pin 1.

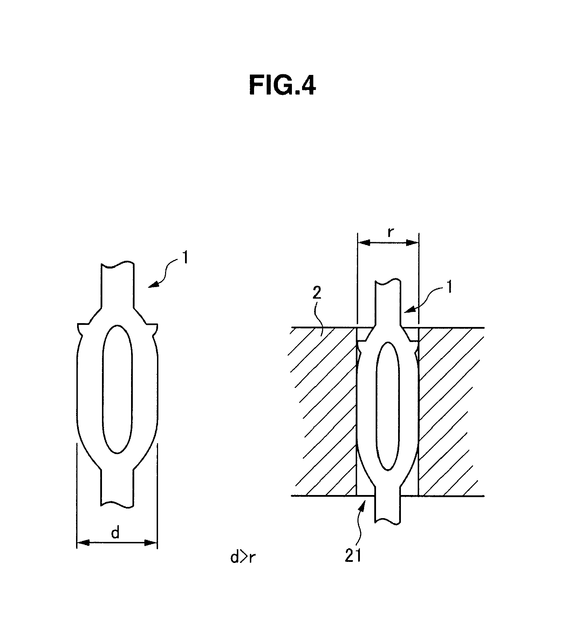

The terminal portion 11 serves as the terminal 31 of the plug connector 3 as described above. The press-fit portion 12 has compressive elasticity in the transverse direction, and ensures its retaining force that derives from frictional contact with the inner circumferential surface 21b of the through-hole 21, thereby mechanically supporting the press-fit pin 1 itself. Therefore, as shown in Fig. 4, the width d at the time when a compressive force in the transverse direction is not applied to the press-fit portion 12 is designed to be slightly larger than the diameter r of the through-hole.

The retaining force of the press-fit pin 1 needs to be sufficiently larger than the extraction force that acts on the plug connector 3. The extraction force F1 acting on the plug connector 3 generally satisfies the condition 0.2N ≤ F1 ≤ 0.4N. Accordingly, the retaining force of the press-fit pin 1 is preferably set to be about ten times stronger than the extraction force.

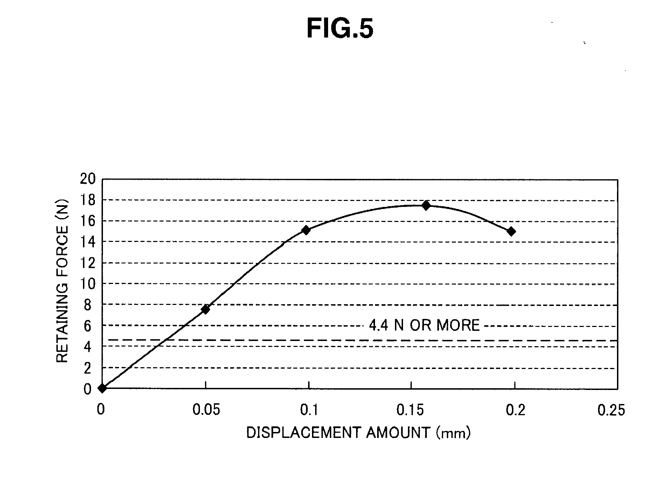

For example, when assuming that the width d of the press-fit portion 12 of the press-fit pin 1 is 0.78 mm and the diameter r of the through-hole 21 is 0.6 mm, the relationship between the displacement amount of the width d and the retaining force of the press-fit portion 12 is shown in Fig. 5. According to the figure, it can be said the displacement amount needs to be 0.05 mm or more in order to ensure 4.4 N or more for the retaining force of the press-fit pin 1. Therefore, the diameter of the through-hole 21 in the printed wiring board 2 is required to be 0.73 mm or less relative to the press-fit pin 1 having the press-fit portion 12 with the width d of 0.78 mm. In this embodiment, the press-fit portion 12 is formed with a slit portion 121 in a longitudinal direction of the press-fit pin 1 in order to ensure a sufficient displacement amount in the transverse direction.

Also, the press-fit portion 12 has plane-shaped contact portions 122 in order to enhance its interference force with the inner circumferential surface 21 b of the through-hole 21 and enable connection with the electrode portion 221 at an arbitrary depth position in the through-hole 21. The press-fit portion 12 of the press-fit pin 1 is also provided with lock portions 123 at both ends of its upper portion. In this embodiment, each lock portion 123 is formed as a claw-shaped protruding portion that extends transversely. Preferably, the shape of the lock portion 123 is selected so that the locking force increases with respect to the inner circumferential surface 21 b of the through-hole 21 in the direction of extraction of the press-fit pin 1.

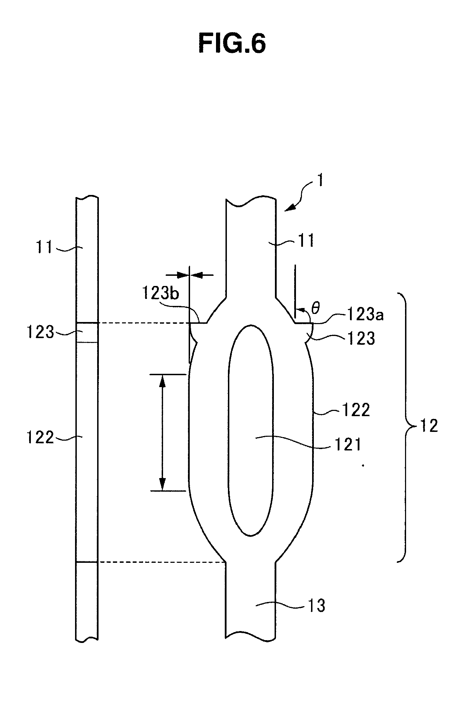

Fig. 6 shows a partial side view and a partial frontal view illustrating the press-fit portion 12 of the press-fit pin 1 according to an embodiment of the invention. As shown in Fig. 6, each contact portion 122 is formed substantially in parallel with the longitudinal direction of the press-fit pin 1 when viewed from the front side.

The lock portions 123 are arranged at both upper end portions of the press-fit portion 12. The lock portions 123 are arranged on either the upper side or the lower side of the press-fit portion 12, and accordingly, the correct direction of the press-fit pin 1 can be ascertained easily. This leads to improved operation efficiency during assembly. In this embodiment, the lock portions 123 are provided above the contact portions 122 (that is, on the terminal portion side), but the position is not limited to this case. For example, the lock portions may be provided below the contact portions 122 (that is, on the tip end portion side). Alternatively, they may be provided at four upper and lower parts. Even in this case, the correct direction of the press-fit pin 1 can be confirmed easily based on the shape of the lock portions 123.

A top portion 123a of each lock portion 123 is formed to have the same height of a plane surface of each contact portion 122 or be slightly higher than the plane surface. The lock portion 123 is formed to have a tapered shape that starts from the top portion 123a toward the contact portion 122. It is preferable for the tapered shape to be gentle so as to not inhibit the insertion of the press-fit pin 1. The lock portion 123 is also formed with a locking surface 123b in order to ensure the sufficient locking force relative to the inner circumferential surface 21 b of the through-hole 21 in the direction of extraction of the press-fit pin 1. Therefore, it is preferable that an angle θ, which is formed by the locking surface 123b and a longitudinal surface of the press-fit pin 1 be, for example, 90 degrees or less. In general, where the press-fit pin 1 is held by being made to interfere with the non-plated through-hole 21, the retaining force may drop. However, the contact portion 122 has a sufficient area, which ensures sufficient retaining force. Also, the lock portion 123 engages with the inner circumferential surface 21 b of the through-hole 21 with respect to the extraction force of the press-fit pin 1. Thus, the press-fit pin 1 can be prevented from coming loose.

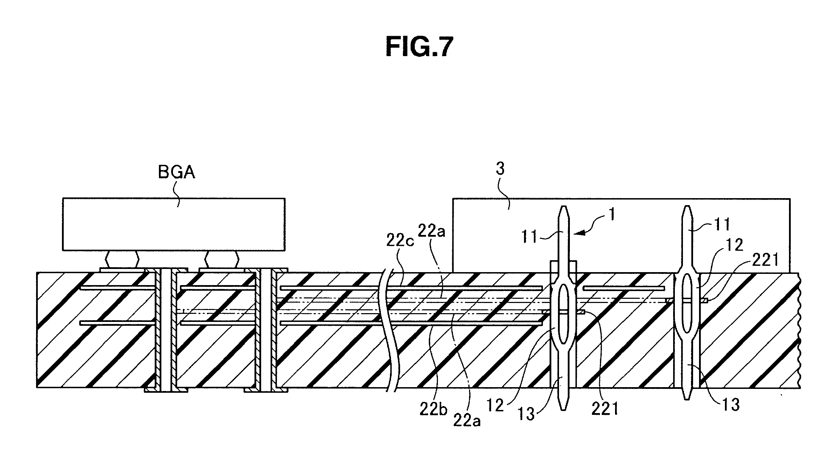

Fig. 7 is a diagram illustrating a mounted state of the printed wiring board 2 using the press-fit pins 1 according to an embodiment of the invention.

As shown in Fig. 7, the multilayer printed wiring board 2 has the wiring patterns 22 formed in its respective layers. The printed wiring board 2 is formed with the plural through-holes 21, and the wiring patterns 22 in the layers are appropriately led to the predetermined through-holes 21. In this example, shown are the signal transmission wiring patterns 22a, the power supply wiring pattern 22b, and the ground wiring pattern 22c. In the figure, only the four wiring patterns 22 are shown; however, the wiring patterns 22 are actually formed in accordance with the number of laminated wiring layers. Basically, in each layer, the wiring patterns 22 are arranged parallel in a direction horizontal to the printed wiring board 2. At the same time, the wiring patterns 22 in the respective layers are aligned in a direction perpendicular to the printed wiring board 2. Some through-holes 21 have been subjected to plating of the inner circumferential surface 21 b, and are electrically connected to the electrode pads of an LSI such as a BGA (Ball Grid Array) which is mounted on the surface of the printed wiring board 2.

The press-fit pin 1 is press-fitted into the non-plated through-hole 21, thereby mechanically retaining the housing of the plug connector 3, and making the plug connector 3 attached to the printed wiring board 2.

Also, as described above, the electrode portion 221 of the wiring pattern 22 is exposed at the inner circumferential surface 21b of the non-plated through-hole 21, and the electrode portion 221 is electrically in contact with the press-fit portion 12 of the press-fit pin 1.

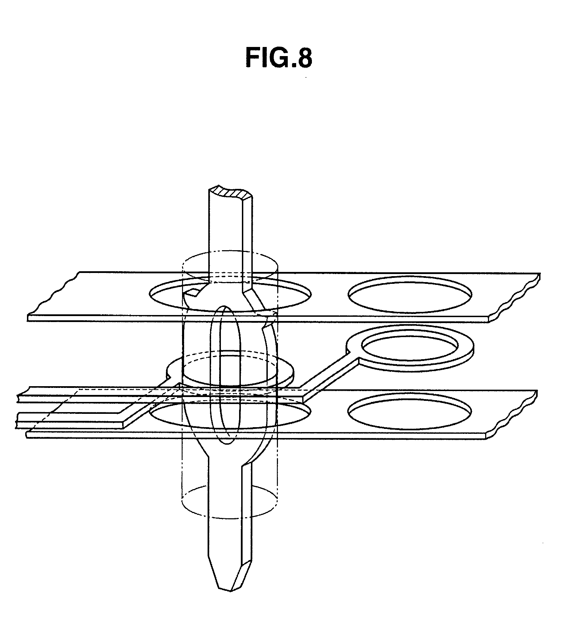

Fig. 8 is a diagram illustrating the press-fit pin 1 in the through-hole 21 according to an embodiment of the invention. Specifically, the figure describes the electrical connection state between the press-fit pin 1 in the through-hole 21 and the various wiring patterns. Accordingly, the parts other than the press-fit pin 1 and the wiring patterns have been omitted in the figure.

More specifically, as shown in Fig. 8, the electrode portion 221 of the signal transmission wiring pattern 22a is formed in a circular shape, and is exposed as it is because the inner circumferential surface 21 b of the through-hole 21 has not been subjected to plating. Therefore, the electrode portion is not formed covering the entire inner circumferential surface 21 b of the through-hole 21, which suppresses the electrostatic capacitance of the through-hole 21. As a result, the invention is applicable also in a high-speed signal transmission system.

The power supply wiring pattern 22b and the ground wiring pattern 22c each have an opening portion with a larger diameter than that of the through-hole 21 so as to not be exposed at the inner circumferential surface 21 b of the through-hole 21. By way of this, the press-fit pin 1, which is press-fitted into the through-hole 21, allowing selective electrical connection with a desired wiring pattern.

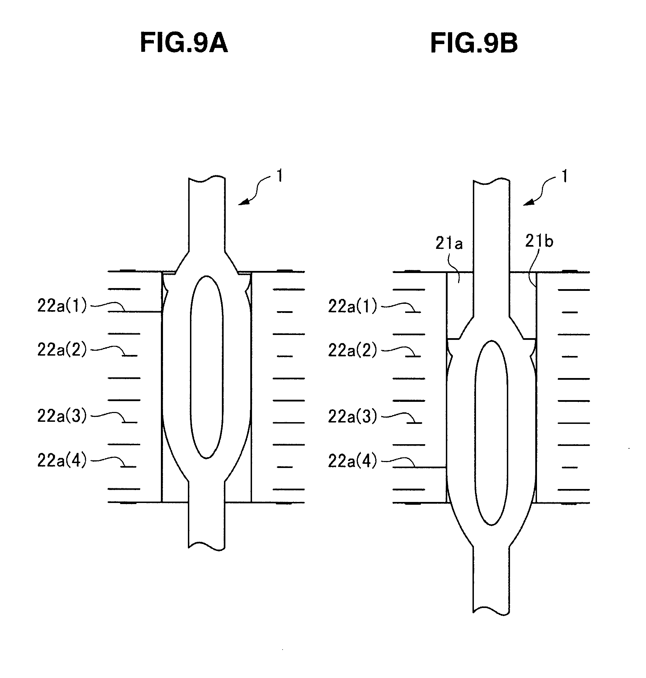

Figs. 9A and 9B are diagrams illustrating the connection relationship between the press-fit pin 1 and the signal transmission wiring pattern 22a in the printed wiring board 2 according to an embodiment of the invention. In the figures, signal transmission wiring patterns 22a(1) to 22a(4) are formed in respective wiring layers in the multilayer printed wiring board 2.

In order for the press-fit pin 1 to effectively come into contact with the wiring patterns 22 at different depth positions in the through-hole 21, having the contact portion 122 of the press-fit portion 12 be designed to be as wide (long) as possible is effective. This enables absorption of design errors. Furthermore, where the wiring pattern 22 is formed near a surface layer of the printed wiring board 2, or where the thickness of the printed wiring board 2 is sufficient relative to the length of the contact portion 122, the press-fit pin 1 can be made to come into electrical contact with the wiring pattern 22 at a position of desired depth by changing the insertion depth of the press-fit pin 1.

More specifically, in Fig. 9A, the press-fit pin 1 is in electrical contact with, in the through-hole 21, the signal transmission wiring pattern 22a(1) in the wiring layer positioned as an upper layer of the printed wiring board 2. On the other hand, in Fig. 9B, the press-fit pin 1 is in electrical contact with the signal transmission wiring pattern 22a(4) in the wiring layer positioned as a lower layer of the printed wiring board 2.

As described above, according to this embodiment, regarding the through-hole 21 for connecting the press-fit pin 1 with the signal transmission wiring pattern 22a, the electrode portion is not formed covering the entire inner circumferential surface 21 b, and only the signal transmission wiring pattern 22a is exposed. As a result, the electrostatic capacitance of the through-hole 21 can be kept low. Therefore, even in the event of transmission of a signal in a high rate band, the occurrence of impedance mismatching in the through-hole 21 can be prevented. As a result, satisfactory signal characteristics can be obtained.

Also, plating is not performed on the entire inner circumferential surface 21 b of the through-hole 21, which may lead to the retaining force of the reduced press-fit pin 1. However, the contact portion 122 of the press-fit portion 12, which extends substantially in parallel with the longitudinal direction of the press-fit pin 1, is formed, preventing any reduction in the retaining force. Also, the formed lock portions 123 definitely engage with the inner circumferential surface 21 b of the through-hole 21 in the direction of extraction of the press-fit pin 1. Accordingly, the press-fit pin 1 is prevented from coming loose.

The above embodiment is just an example of the invention for explanation purposes, and accordingly, the invention is not limited to that embodiment. The invention can be implemented in various forms without departing from the scope of the invention.

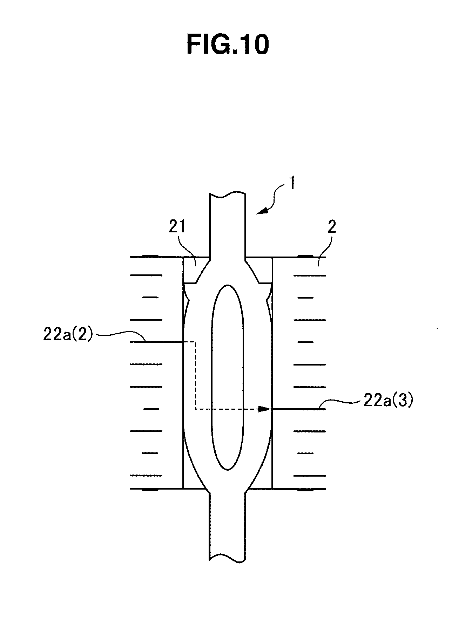

Fig. 10 is a diagram showing an application example of the press-fit pin 1 and the printed wiring board 2 according to the embodiment of the invention. Fig. 10 shows an example in which the press-fit pin 1 is used as a jumper pin. The wiring patterns 22a(2) and 22a(3), which are formed in different wiring layers in the printed wiring board 2, are electrically connected to each other via the press-fit pin 1. In this case, the terminal portion 11 is not necessarily formed.

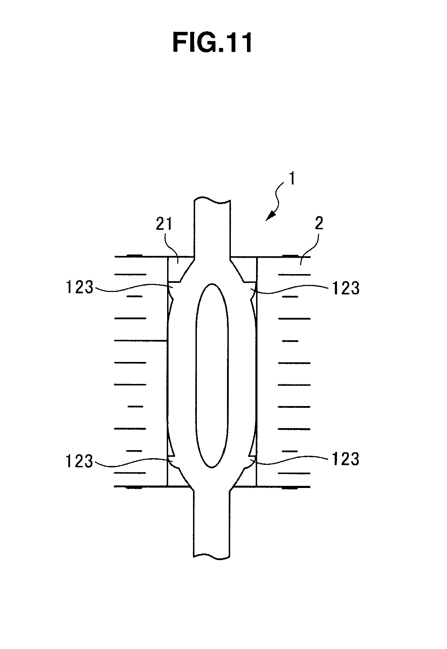

Fig. 11 is a diagram illustrating a modified example of the press-fit pin 1 according to the embodiment of the invention. The press-fit pin 1 shown in Fig. 11 is provided with the lock portions 123 at the upper and lower ends of the press-fit portion 12, and the four lock portions 123 engage with the inner circumferential surface 21 b of the through-hole 21 in the direction of extraction. As a result, the sufficient retaining force of the press-fit pin 1 is ensured. Therefore, the press-fit pin 1 can be prevented from coming loose more reliably.

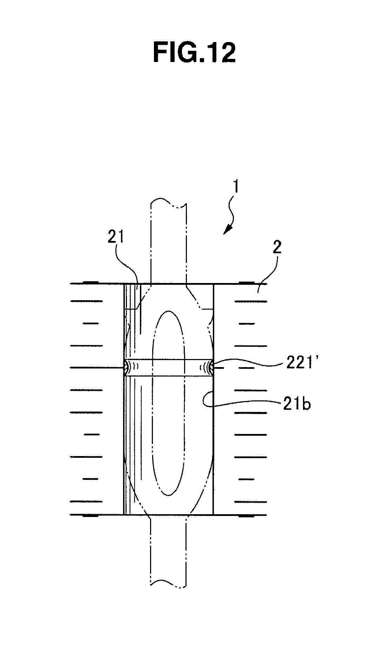

Fig. 12 shows a modified example of the printed wiring board 2 according to an embodiment of the invention. In this embodiment, the signal transmission wiring pattern 22a itself is exposed at the inner circumferential surface 21 b of the through-hole 21 to form the electrode portion 221. However, the thickness of the electrode portion 221 is about 35 µm, and it consequently may not ensure electrical connection due to a slight tilt of the press-fit pin 1, or something similar. Therefore, in this modified example, an electrode portion 221' having increased contact area is formed on the inner circumferential surface 21b of the through-hole 21. The electrode portion 221' is formed by, for instance, a vapor phase growth method.

The invention is widely applicable in a junction technique using a press-fit pin. In particular, the invention is applicable to a multilayer print wiring board, which is required to deal with signal transmission with a high rate (high-frequency band), and a press-fit pin attached to the printed wiring board.

## Claims

1. A board formed with a first through-hole, comprising:
at least one signal transmission layer;
a signal transmission wiring pattern formed in the signal transmission layer; and
an electrode portion of the signal transmission wiring pattern, the electrode portion being exposed at an inner circumferential surface of the first through-hole.

2. The board according to claim 1, wherein the electrode portion is formed only at a part of the inner circumferential surface of the first through-hole.

3. The board according to claim 2, further comprising at least one of a power supply layer and a ground layer, wherein a non-signal transmission wiring pattern formed in at least one of the power supply layer and the ground layer is formed with an opening portion that surrounds the first through-hole so as to not be exposed at the inner circumferential surface of the first through-hole.

4. The board according to claim 3, wherein the board is formed with a second through-hole, and wherein an electrode portion electrically connected with the non-signal transmission wiring pattern is formed covering the entire inner circumferential surface of the second through-hole.

5. The board according to claim 4, further comprising a press-fit pin that is fitted into at least one of the first through-hole and the second through-hole to be electrically connected with one of the electrode portions.

6. The board according to claim 5, further comprising a plug connector held by the press-fit pin.

7. A press-fit pin for press-fitting into a through-hole formed in a multilayer board, comprising:
a terminal portion;
a press-fit portion connected with the terminal portion and having compressive elasticity in a transverse direction; and
a tip end portion connected with the press-fit portion,
wherein the press-fit portion has a lock portion configured to engage with an inner circumferential surface of the through-hole in a direction of extraction of the press-fit pin.

8. The press-fit pin according to claim 7, wherein the press-fit portion has a contact portion having a surface that extends substantially in parallel with a longitudinal direction of the press-fit pin.

9. The press-fit pin according to claim 8, wherein the board includes at least one signal transmission layer, a signal transmission wiring pattern formed in the signal transmission layer, and an electrode portion of the signal transmission wiring pattern exposed at the inner circumferential surface of the through-hole, and wherein the press-fit portion of the press-fit pin is electrically connected with the electrode portion exposed at the inner circumferential surface of the through-hole.

10. The press-fit pin according to claim 9, wherein the electrode portion is formed only at a part of the inner circumferential surface of the through-hole.
